Europäisches Patentamt

European Patent Office

Office européen des brevets

(19)

(11) EP 0 476 341 B1

## (12) EUROPEAN PATENT SPECIFICATION

(45) Date of publication and mention
of the grant of the patent:
**15.01.1997 Bulletin 1997/03**

(51) Int Cl.⁶: **H03K 19/20**, H03K 19/0175,
H03K 19/086

(21) Application number: **91114028.3**

(22) Date of filing: **22.08.1991**

(54) **A BICMOS logic circuit with a CML output**

Logischer BICMOS Schaltkreis mit einem CML-Ausgang

Circuit logique BICMOS avec une sortie CML

(84) Designated Contracting States:
**DE FR GB**

(30) Priority: **29.08.1990 US 574178**

(43) Date of publication of application:
**25.03.1992 Bulletin 1992/13**

(73) Proprietor: **MOTOROLA, INC.**
**Schaumburg, IL 60196 (US)**

(72) Inventor: **Huehne, Karl Jackson**
**Austin, Texas 78746 (US)**

(74) Representative: **Lupton, Frederick et al**
**Motorola European Intellectual Property,**
**Midpoint,**
**Alencon Link**
**Basingstoke, Hampshire RG21 1PL (GB)**

(56) References cited:
EP-A- 0 176 799          EP-A- 0 300 698
EP-A- 0 363 189          EP-A- 0 430 653
US-A- 1 516 817          US-A- 4 517 476
US-A- 4 551 638          US-A- 4 551 639
US-A- 4 559 458          US-A- 4 675 554
US-A- 4 680 486          US-A- 4 695 750
US-A- 4 877 977          US-A- 4 928 025

## Description

### Field of the Invention

This invention relates generally to logic circuits, and more particularly, to BICMOS logic circuits for receiving at least one CMOS-level input signal and for providing a CML-level output signal.

### Background of the Invention

One type of integrated circuit logic which uses bipolar transistors is called emitter-coupled logic (ECL). ECL logic circuitry has the advantages that it is very fast, and has high input resistance, low output resistance, and low noise generation. ECL signal levels, referenced to a power supply voltage terminal commonly labelled $V_{CC}$, are approximately ($V_{CC}$ - $V_{BE}$) for a logic high voltage, and ($V_{CC}$ - $2V_{BE}$) for a logic low voltage, where $V_{BE}$ is the forward biased base-emitter diode voltage drop of a corresponding bipolar transistor. In order to provide the logic high voltage ($V_{CC}$ - $V_{BE}$), however, an extra transistor is necessary. A similar type of logic using bipolar transistors known as current-mode logic (CML) eliminates the need for an extra transistor by providing a logic high voltage of $V_{CC}$, and a logic low voltage of approximately ($V_{CC}$ - $V_{BE}$). The output level is thus more constrained but in many cases the saving of a transistor is advantageous.

Metal oxide semiconductor (MOS) transistors are now commonly being fabricated in integrated circuits along with bipolar transistors. As a result, some logic circuits providing CML-level output signals are required to receive at least one input signal compatible with the MOS transistors in addition to receiving at least one CML-level input signal. Complementary metal oxide semiconductor (CMOS) signal levels differ from ECL and CML signal levels. A CMOS logic high voltage is approximately $V_{CC}$, whereas a logic low voltage is approximately a second power supply voltage, commonly labelled "$V_{SS}$", which is negative with respect to $V_{CC}$. However when CMOS levels are applied to a base of a bipolar transistor in a CML logic circuit, reliability problems can result because of the differences in logic levels. A large reverse bias which occurs if a CMOS logic low voltage (about $V_{SS}$) is applied to the base of an input bipolar transistor while the emitter is held at or near a CML logic high voltage ($V_{CC}$) is harmful to the operation of the input bipolar transistor. When a large reverse bias is applied across the base-emitter junction of a bipolar transistor, degradation occurs. Over time, the constant application of this large reverse bias may cause the input bipolar transistor to fail, resulting in a failure of the entire integrated circuit. Electronically, a large reverse bias on a PN junction causes hot carrier injection into the overlying oxide, resulting in poor junction performance. See, for example, "Hot-Carrier Degradation in Bipolar Transistors at 300 and 110 K - Effect on BiCMOS Inverter Performance", by Burnett and Hu in IEEE Transactions on Electron Devices, vol. 37, no. 4, April 1990, pp. 1171-1173. The amount of hot carrier injection is proportional to the time the reverse bias occurs. The size of the reverse bias is related to the mean life of the transistor, for given worst case conditions, by an inverse semilogarithmic relationship; as the reverse bias decreases linearly, mean life increases exponentially. At typical values for reverse bias, transistor mean life in a mixed CML-CMOS logic circuit may be unacceptably short.

EP-A-0 363 189 teaches a BICMOS logic circuit which includes an input bipolar transistor and a reference bipolar transistor having emitters coupled together and to a current source. The current source is coupled to the negative supply potential through a parallel combination of a resistor and an MOS transistor switched by a logic signal.

### Summary of the Invention

It is an object of the invention to reduce the problems mentioned above.

In accordance with a first aspect of the invention there is provided a BICMOS logic circuit as claimed in claim 1.

In accordance with a second aspect of the invention there is provided a BICMOS logic circuit as claimed in claim 7.

These and other objects, features and advantages will be more clearly understood from the following detailed description taken in conjunction with the accompanying drawings.

### Brief Description of the Drawings

FIG. 1 illustrates in schematic form a known logic circuit;
FIG. 2 illustrates in schematic form a logic circuit in accordance with the present invention;
FIG. 3 illustrates in schematic form a second embodiment of the logic circuit of the present invention;
FIG. 4 illustrates in schematic form a third embodiment of the logic circuit of the present invention; and
FIG. 5 illustrates in schematic form a logic circuit in accordance with a preferred embodiment of the present invention.

### Detailed Description of the Invention

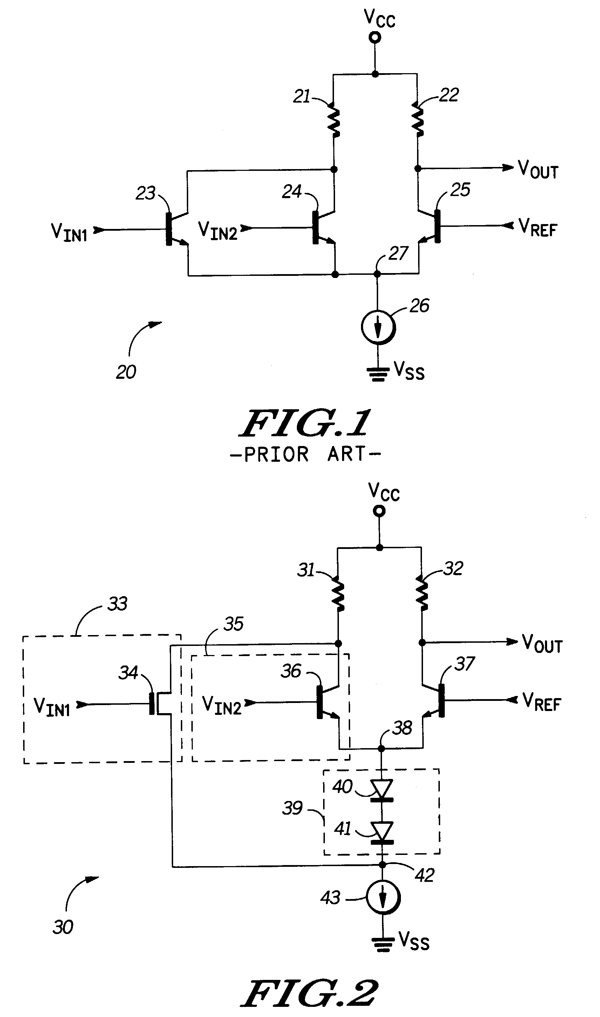

FIG. 1 illustrates in schematic form a known logic circuit 20. Logic circuit 20 comprises resistors 21 and 22, NPN transistors 23, 24, and 25, and a current source 26. Resistor 21 has a first terminal connected to a positive power supply voltage terminal labelled "$V_{CC}$", and a second terminal. Resistor 22 has a first terminal connected to $V_{CC}$, and a second terminal. Transistor 23 has a collector connected to the second terminal of resistor 21, a base for receiving an input signal labelled "$V_{IN1}$", and an emitter connected to a node 27. Transistor 24 has a collector connected to the second terminal of resistor 21, a base for receiving a second input signal labelled "$V_{IN2}$", and an emitter connected to the emitter of transistor 23 at node 27. Transistor 25 has a collector connected to the second terminal of resistor 22 and providing an output signal labelled "$V_{OUT}$" thereon, a base for receiving a reference voltage labelled "$V_{REF}$", and an emitter connected to the emitters of transistors 23 and 24 at node 27. Current source 26 has a first terminal connected to the emitters of transistors 23, 24, and 25 at node 27, and a second current electrode connected to a negative power supply voltage terminal labelled "$V_{SS}$". Current source 26 provides a constant current having a positive magnitude when designated as flowing from a terminal at a more-positive voltage to a terminal at less-positive voltage. In FIG. 1, the first terminal of current source 26 is more positive in voltage with respect to the second terminal of current source 26, and a positive current flows in the direction from the first terminal to the second terminal. Thus, current source 26 is designated generically rather than being specified as a current source or a current sink.

Circuit 20 is a logic OR gate providing signal $V_{OUT}$ as a logical OR of input signals $V_{IN1}$ and $V_{IN2}$ at CML signal levels. The logic high voltage of signal $V_{OUT}$ is equal to $V_{CC}$, and the logic low voltage is approximately equal to $(V_{CC} - I_{26}R_{22})$, where $I_{26}$ is equal to the constant current of current source 26, and $R_{22}$ is the resistance of resistor 22. $V_{REF}$ is a reference voltage set approximately halfway between $V_{CC}$ and $(V_{CC} - I_{26}R_{22})$. The values of signals $V_{IN1}$ and $V_{IN2}$ determine whether the logic high voltage or the logic low voltage is provided on signal $V_{OUT}$. If either signal $V_{IN1}$ or signal $V_{IN2}$ or both exceeds $V_{REF}$ by a minimum amount, then the current of current source 26, $I_{26}$, is steered through the corresponding transistor or transistors and not through transistor 25. In that case resistor 22 pulls signal $V_{OUT}$ to approximately $V_{CC}$. If however signals $V_{IN1}$ and $V_{IN2}$ are both less than $V_{REF}$ by a minimum amount, then transistor 25 is relatively more conductive than transistors 23 and 24 and substantially all of $I_{26}$ flows through transistor 25, dropping signal $V_{OUT}$ to $(V_{CC} - I_{26}R_{22})$.

If either signal $V_{IN1}$ or signal $V_{IN2}$ is a CMOS-level signal, however, logic circuit 20 has a reliability problem. If signal $V_{IN1}$ is the CMOS-level signal, then the logic high voltage is approximately $V_{CC}$, and the logic low voltage is approximately $V_{SS}$. $V_{REF}$ sets the voltage on the emitter of transistor 25 to $(V_{REF} - V_{BE})$, where $V_{BE}$ is the base-emitter diode voltage drop of transistor 25. Therefore a relatively large reverse bias may develop across the base-emitter junction of transistor 23, equal to approximately $(V_{REF} - V_{BE} - V_{SS})$. For typical applications, $V_{CC} = 5$ volts, $V_{SS} = 0$ volts, $V_{REF} = 4.85$ volts, and $V_{BE} = 0.85$ volts. Therefore, a reverse bias of approximately 4 volts is possible if signal $V_{IN1}$ is a CMOS-level input. The size of the reverse bias is related to the mean life of the transistor, for given worst case conditions, by an inverse semilogarithmic relationship; as the reverse bias decreases linearly, mean life increases exponentially. At a reverse bias of 4 volts when signal $V_{IN1}$ is a logic low of approximately $V_{SS}$, transistor 23 will have an unacceptably short mean life.

FIG. 2 shows a logic circuit 30 in accordance with the present invention. Logic circuit 30 comprises resistors 31 and 32, a CMOS transistor portion 33, a bipolar transistor portion 35, an NPN reference transistor 37, voltage dropping portion 39, and a current source 43. In the illustrated embodiment, CMOS transistor portion 33 comprises an N-channel transistor 34, and bipolar transistor portion 35 comprises an NPN transistor 36. Voltage dropping portion 39 comprises diodes 40 and 41. Resistor 31 has a first terminal connected to $V_{CC}$, and a second terminal. Resistor 32 has a first terminal connected to $V_{CC}$, and a second terminal. Transistor 34 has a drain connected to the second terminal of resistor 31, a gate for receiving signal $V_{IN1}$, and a source connected to a node 42. Transistor 36 has a collector connected to the second terminal of resistor 31, a base for receiving signal $V_{IN2}$, and an emitter connected to a node 38. Transistor 37 has a collector connected to the second terminal of resistor 32 and providing signal $V_{OUT}$ thereon, a base for receiving $V_{REF}$, and an emitter connected to the emitter of transistor 36 at node 38. Diode 40 has a positive terminal connected to the emitters of transistors 36 and 37 at node 38, and a negative terminal. Diode 41 has a positive terminal connected to the negative terminal of diode 40, and a negative terminal connected to the source of transistor 34 at node 42. Current source 43 has a first terminal connected to the source of transistor 34 and to the negative terminal of diode 41 at node 42, and a second terminal connected to $V_{SS}$.

Logic circuit 30 is a two-input OR gate like logic circuit 20 of FIG. 1. In logic circuit 30, N-channel MOS transistor 34 in CMOS transistor portion 33 is used instead of an NPN bipolar transistor to receive the CMOS-level input signal $V_{IN1}$. Therefore, no bipolar transistor is subjected to large reverse bias on its base-emitter junction due to the higher CMOS levels, like transistor 23 in FIG. 1. However instead of being connected to the emitters of transistors 36 and 37, the source of transistor 34 is separated by diodes 40 and 41, forming voltage dropping portion 39, from the emitters of transistors 36 and 37. At typical values for $V_{CC}$ and $V_{SS}$, 5.0 volts and 0 volts respectively, the voltage on node 38 ($V_{38}$) is equal to 4.0 volts. Then if transistor 34 were connected to the emitters of transistors 36 and 37, the source voltage would be set at 4.0 volts. The logic high voltage of signal $V_{IN1}$ is equal to approximately $V_{CC}$, or 5.0 volts. Thus the gate-to-source voltage ($V_{GS}$) of transistor 34 when signal $V_{IN1}$ is at a logic high would not exceed 1 volt. A $V_{GS}$ of 1 volt is insufficient to divert substantially all the current flowing through current source 43 ($I_{43}$) through transistor 34 without substantially reducing its threshold voltage, which may be possible only by making the gate size of transistor 34 extremely large. However in logic circuit 30, the voltage on the source of transistor 34 is reduced by two diode drops, or about 1.8 volts, from $V_{38}$. With typical values, then the voltage on the source of transistor 34 is at 2.2 volts, providing a $V_{GS}$ of transistor 34, when signal $V_{IN1}$ is a logic high, of 2.8 volts. The increased $V_{GS}$ is sufficient to divert substantially all the current of current source 43 through transistor 34.

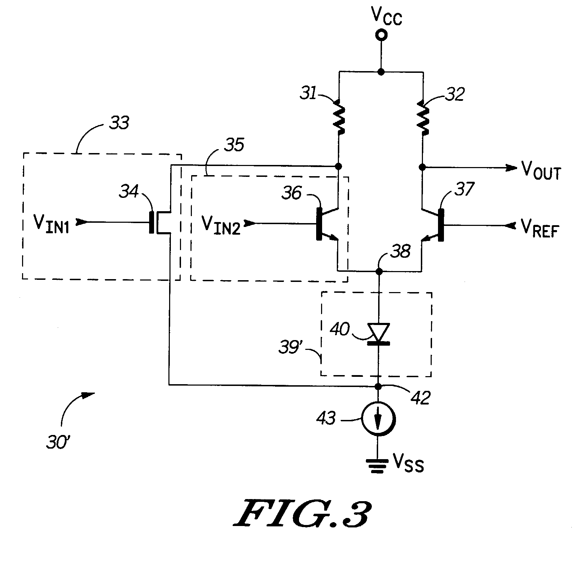

FIG. 3 shows an alternative embodiment 30' of logic circuit 30 of FIG. 2, which is useful when $V_{CC}$ is substantially less than 5 volts. For ease of illustration elements in common with FIG. 2 are similarly numbered. Each element is the same with the exception that voltage dropping portion 39' comprises a single diode 40 having a positive terminal connected to node 38, and a negative input terminal connected to the first terminal of current source 43 at node 42. If $V_{CC}$ is substantially less than 5 volts, circuit 30' is preferred. There is a tradeoff between the $V_{GS}$ of transistor 34, and the gain of logic circuit 30'; if $V_{CC}$ is reduced well below 5 volts, then the tradeoff shifts in favor of having a lower $V_{GS}$ on transistor 34 when signal $V_{IN1}$ is a logic high, and an increased gain.

Returning now to FIG. 2, it should be apparent that other methods of dropping a voltage between node 38 and node 42 are possible including, but not limited to, using a resistor, using two bipolar transistors serially each with a collector connected to a base, and using two N-channel MOS transistors serially each with a drain connected to a gate. Also note that while a two-input OR gate was illustrated, OR gates with more inputs are possible by increasing the number of transistors in portions 33 and 35. For each additional CMOS input, an N-channel transistor having a drain connected to the second terminal of resistor 31, a gate for receiving the CMOS-level input signal, and a source connected to node 42 must be provided. For each additional CML-level input, an NPN transistor having a collector connected to the second terminal of resistor 31, a base for receiving the CML-level input signal, and an emitter connected to node 38 must be provided. It should also be noted that in another embodiment bipolar transistor portion 35 may be omitted. Then if only a single input is received on the gate of a MOS transistor in CMOS transistor portion 33, the function performed would be a level conversion from a CMOS-level input signal to a CML-level output signal. If further CMOS input signals were received, then the function performed would be a logical OR between each of the input signals.

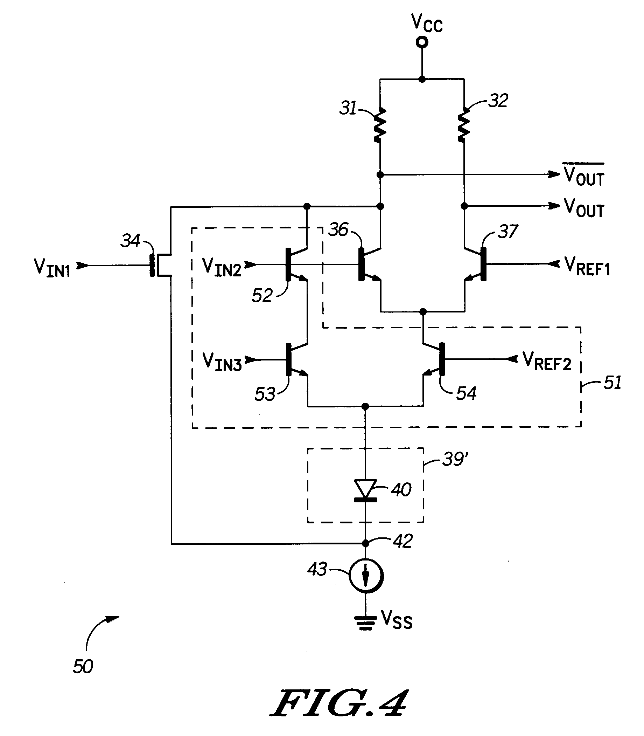

FIG. 4 illustrates in schematic form a logic circuit 50 in accordance with a third embodiment of the present invention. For ease of illustration elements in common with FIGs. 2 and 3 are similarly numbered. Logic circuit 50 includes resistors 31 and 32, N-channel transistor 34, NPN transistors 36 and 37, voltage dropping portion 39', and current source 43 as previously illustrated in FIG. 3. Resistor 31 has a first terminal connected to $V_{CC}$, and a second terminal for providing a signal labelled "$\overline{V_{OUT}}$". Resistor 32 has a first terminal connected to $V_{CC}$, and a second terminal for providing signal $V_{OUT}$. Transistor 34 has a drain connected to the second terminal of resistor 31, a gate for receiving signal $V_{IN1}$, and a source connected to node 42. Transistor 36 has a collector connected to the second terminal of resistor 31, a base for receiving signal $V_{IN2}$, and an emitter. Transistor 37 has a collector connected to the second terminal of resistor 32, a base for receiving a reference voltage labelled "$V_{REF1}$", and an emitter connected to the emitter of transistor 36. As in FIG. 3, voltage dropping portion 39' includes a single diode having a positive terminal, and a negative terminal connected to the source of transistor 34 at node 42. Current source 43 has a first terminal connected to the source of transistor 34 and to the negative terminal of diode 40 at node 42, and a second terminal connected to $V_{SS}$.

In logic circuit 50, however, the positive terminal of diode 40 is coupled to the emitters of transistors 36 and 37 through series gating stage 51. Series gate stage 51 includes NPN transistors 52, 53, and 54. Transistor 52 has a collector connected to the second terminal of resistor 31, a base for receiving signal $V_{IN2}$, and an emitter. Transistor 53 has a collector connected to the emitter of transistor 52, a base for receiving an input signal labelled "$V_{IN3}$", and an emitter connected to the positive terminal of diode 40. Transistor 54 has a collector connected to the emitters of transistors 36 and 37, a base for receiving a reference voltage labelled "$V_{REF2}$", and an emitter connected to the emitter of transistor 53 and to the positive terminal of diode 40.

Logic circuit 50 illustrates another embodiment of the present invention in which an additional logic operation is performed by coupling the emitters of transistors 36 and 37 to voltage dropping portion 39' through series gating stage 51. Series gating stage 51 adds an additional term to the logic function so that logic circuit 50 performs a logical OR of signals $V_{IN1}$, $V_{IN2}$, and $V_{IN3}$. As before, signal $V_{IN1}$ is a CMOS-level signal, with a logic high voltage of approximately $V_{CC}$ and a logic low voltage of approximately $V_{SS}$; $V_{IN2}$ is a CML-level signal with a logic high voltage of $V_{CC}$ and a logic low voltage of ($V_{CC} - I_{43}R_{32}$), where $R_{32}$ is the resistance of resistor 32; and $V_{IN3}$ is a signal with a logic high voltage of about ($V_{CC} - I_{43}R_{32}$), and a logic low voltage of approximately ($V_{CC} - I_{43}R_{32} - V_{BE}$). Thus, $V_{IN3}$ has logic levels one $V_{BE}$ below CML signal levels (i.e., at ECL signal levels). $V_{REF1}$ is a reference voltage set approximately halfway between $V_{CC}$ and ($V_{CC} - I_{43}R_{32}$). However, $V_{REF2}$ is approximately one $V_{BE}$ below $V_{REF1}$ at ($V_{CC} - I_{43}R_{32} - V_{BE}$).

To understand the operation of logic circuit 50, first assume that signal $V_{IN3}$ is at a logic low of ($V_{CC} - I_{43}R_{32} - V_{BE}$). In this case, logic circuit 50 functions as if series gating portion 51 were absent. If $V_{IN1}$ is a logic high, then transistor 34 is conductive making $V_{OUT}$ a logic high and $\overline{V_{OUT}}$ a logic low. If $V_{IN1}$ is a logic low, then transistor 34 is nonconductive, and operation depends on $V_{IN2}$. Since $V_{IN3}$ is less than $V_{REF2}$, transistor 53 is nonconductive, the voltage on the emitters of transistors 36 and 37 drops below the voltage on the emitter of transistor 52, and substantially all of $I_{43}$ is diverted through transistor 54. Then, if $V_{IN2}$ is at a logic high, transistor 36 is conductive and makes $V_{OUT}$ a logic high and $\overline{V_{OUT}}$ a logic low. If however $V_{IN2}$ is at a logic low, then $I_{43}$ is diverted through transistor 37, and $V_{OUT}$ is a logic low with $\overline{V_{OUT}}$ at a logic high.

Next, assume $V_{IN1}$ and $V_{IN2}$ are both a logic low. $V_{IN2}$, a CML-level signal, is at ($V_{CC} - I_{43}R_{32}$). Transistor 52 will remain nonconductive as long as the voltage at the emitter of transistor 52 is greater than ($V_{CC} - I_{43}R_{32} - V_{BE}$). If $V_{IN3}$ is at a logic low, then $I_{43}$ is diverted through transistor 54 at the series gating stage, and through transistor 37. Thus, $V_{OUT}$ is at a logic low. However, if $V_{IN3}$ is a logic high, at ($V_{CC} - V_{BE}$), then transistor 53 becomes conductive, and reduces the voltage at the emitter of transistor 52 to approximately ($V_{CC} - I_{43}R_{32} - V_{BE}$), making transistor 52 conductive. Thus, $I_{43}$ is diverted through transistors 53 and 52 which makes $V_{OUT}$ a logic high and $\overline{V_{OUT}}$ a logic low.

An important advantage to the inclusion of series gating stage 51 is that the capacitance on the second terminal of resistor 31, which provides signal $\overline{V_{OUT}}$, is much less than if the extra term of the logic function were implemented by including a transistor in parallel with transistor 36. Thus, additional terms of the logical-OR function performed by logic circuit 50 may be included without additional capacitive loading on signal $\overline{V_{OUT}}$. Obviously, if signal $V_{IN3}$ were available at the necessary lower logic levels, the use of series gating stage 51 would improve speed while only requiring extra transistors 53 and 54 (the base of transistor 52 would receive $V_{IN3}$, with the emitter of transistor 52 connected to the emitters of transistors 36 and 37). If $V_{IN3}$ were available only at CML logic levels, however, there would be a tradeoff between the additional circuitry required to drop the signal level of $V_{IN3}$ by one $V_{BE}$ and the improvement due to reduced capacitance on the second terminal of resistor 31.

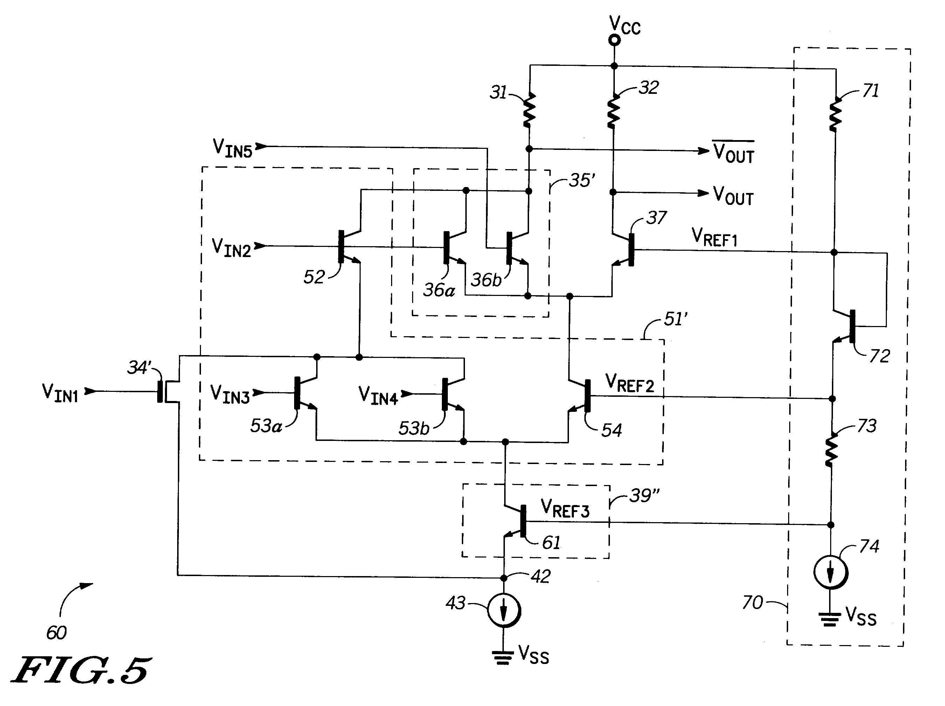

FIG. 5 illustrates in schematic form a logic circuit 60 in accordance with a preferred embodiment of the present invention. As before, elements in common with previous FIGs. will be similarly numbered. As in FIG. 4, logic circuit 60 includes resistors 31 and 32, NPN transistor 37, and current source 43. N-channel transistor 34' replaces transistor 34 of FIGs. 2-4. Bipolar transistor portion 35' replaces bipolar transistor portion 35 of FIGs. 2 and 3 and includes NPN transistors 36a and 36b. Series gating portion 51' replaces series gating portion 51 of FIG. 4 and includes NPN transistors 52, 53a, 53b, and 54. Voltage dropping portion 39" replaces reference voltage portion 39 of FIG. 2 and 39' of FIGs. 3 and 4, and includes an NPN transistor 61. A reference voltage circuit 70 includes a resistor 71, an NPN transistor 72, a resistor 73, and a current source 74.

Resistor 31 has a first terminal connected to $V_{CC}$, and a second terminal for providing signal $\overline{V_{OUT}}$. Resistor 32 has a first terminal connected to $V_{CC}$, and a second terminal for providing signal $V_{OUT}$. In bipolar transistor portion 35', transistor 36a has a collector connected to the second terminal of resistor 31, a base for receiving signal $V_{IN2}$, and an emitter. Transistor 36b has a collector connected to the second terminal of resistor 31, a base for receiving an input signal labelled "$V_{IN5}$", and an emitter connected to the emitter of transistor 36a. Transistor 37 has a collector connected to the second terminal of resistor 32, a base for receiving signal $V_{REF1}$, and an emitter connected to the emitters of transistors 36a and 36b. In series gating portion 51', transistor 52 has a collector connected to the second terminal of resistor 31, a base for receiving signal $V_{IN2}$, and an emitter. Transistor 53a has a collector connected to the emitter of transistor 52, a base for receiving signal $V_{IN3}$, and an emitter. Transistor 53b has a collector connected to the emitter of transistor 52, a base for receiving a signal labelled "$V_{IN4}$", and an emitter connected to the emitter of transistor 53a. Transistor 54 has a collector connected to the emitters of transistors 36a, 36b, and 37, a base for receiving signal $V_{REF2}$, and an emitter connected to the emitters of transistors 53a and 53b. In voltage dropping portion 39", transistor 61 has a collector connected to the emitters of transistors 53a, 53b, and 54, a base for receiving a signal labelled "$V_{REF3}$", and an emitter connected to node 42. Transistor 34' has a drain connected to the emitter of transistor 52, a gate for receiving signal $V_{IN1}$, and a source connected to the emitter of transistor 61 at node 42. Current source 43 has a first terminal connected to the emitter of transistor 61 and to the source of transistor 34' at node 42, and a second terminal connected to $V_{SS}$. In reference voltage circuit 70, resistor 71 has a first terminal connected to $V_{CC}$, and a second terminal for providing signal $V_{REF1}$. Transistor 72 has a collector connected to the second terminal of resistor 71, a base connected to the collector of transistor 72, and an emitter for providing signal $V_{REF2}$. Resistor 73 has a first terminal connected to the emitter of transistor 72, and a second terminal for providing signal $V_{REF3}$. Current source 74 has a first terminal connected to the second terminal of resistor 73, and a second terminal connected to $V_{SS}$.

There are three principal differences between logic circuit 60 and logic circuit 50 of FIG. 4, which are best understood by comparing the differences. First, logic circuit 60 performs a logical OR of five input signals. Of the five input signals, one ($V_{IN1}$) is a CMOS-level signal received by transistor 34'. Two signals ($V_{IN2}$ and $V_{IN5}$) are CML logic signals received by transistors 36a and 52, and 36b, respectively. Two others ($V_{IN3}$ and $V_{IN4}$) are ECL-level signals, or alternatively, CML-level signals reduced in voltage by $V_{BE}$, received by transistors 53a and 53b, respectively. Second, the drain of transistor 34' is connected to the emitter of transistor 52, rather than to the second terminal of resistor 31, to further reduce the capacitance on a critical output node providing $\overline{V_{OUT}}$. Third, voltage dropping portion 39" includes transistor 61. Instead of transistor 61 having its base connected to its collector, to function as a diode, its base receives signal $V_{REF3}$. $V_{REF3}$ is a voltage slightly greater than the voltage at the collector of transistor 39''. Increasing $V_{REF3}$ above the voltage at the collector of transistor 61 allows transistor 61 to go into saturation and to provide operation at a lower voltage for $V_{CC}$.

In bias circuit 70, $V_{REF1}$ is provided at $(V_{CC} - I_{74}R_{71})$, a voltage which is about halfway between the CML signal swing from $V_{CC}$ to $(V_{CC} - I_{43}R_{32})$, where $I_{74}$ is the current of current source 74, and $R_{71}$ is the resistance of resistor 71. Transistor 72 is diode-connected to reduce voltage $V_{REF2}$ to an amount equal to the voltage at the second terminal of resistor 71 minus one $V_{BE}$. Resistor 73 further reduces the voltage to provide $V_{REF3}$ to transistor 61.

Logic circuit 60 thus provides the advantage that ECL-level logic signals may also be combined with CMOS- and CML-level signals while retaining the advantages of the present invention as previously described in connection with FIG. 3. Also, the extra logic inputs may be received without capacitively loading the second terminal of resistor 31, which may be a critical output node in certain applications. Additional CML-level input signals may be level-shifted downward by one $V_{BE}$ and received by transistors such as 53a to further offload the critical node. Thus, logic circuit 60 provides additional flexibility.

It should be apparent by now that a logic circuit for receiving at least one CMOS-level input signal and at least one CML-level input signal has been described. A bipolar transistor portion comprises at least one bipolar transistor each having a collector coupled through a first resistor to a first power supply voltage terminal, a base for receiving a respective CML-level input signal, and an emitter. A reference bipolar transistor has a collector connected to the first power supply voltage terminal through a second resistor, a base for receiving a reference voltage, and an emitter connected to the emitter of each transistor in the bipolar transistor portion. A CMOS transistor portion comprises at least one CMOS transistor each having a first current electrode connected to the first resistor, a gate for receiving a respective CMOS-level input signal, and a second current electrode. The second current electrode of the CMOS transistor is separated from the voltage on the emitters of the two bipolar transistors by, for example, two diode voltage drops. The bipolar and CMOS transistors steer a current provided by a current source to provide an output signal on the collector of the reference bipolar transistor.

While the invention has been described in the context of a preferred embodiment, it will be apparent to those skilled in the art that the present invention may be modified in numerous ways and may assume many embodiments other than that specifically set out and described above. For example, the conductivities of the transistors could be reversed and the circuit inverted to provide a different logic function.

## Claims

1. A BICMOS logic circuit (30, 30', 50) comprising a first resistor (31) having a first terminal coupled to a first power supply voltage terminal, and a second terminal, a second resistor (32) having a first terminal coupled to said first power supply voltage terminal, and a second terminal, a reference transistor (37) having a collector coupled to said second terminal of said second resistor (32), a base for receiving a reference voltage, and an emitter, and a current source (43) coupled to a first power supply voltage terminal, characterised by further comprising:

   voltage dropping means (39, 39', 51) for providing a voltage differential between first and second terminals thereof, said first terminal coupled to said emitter of said reference transistor (37), said second terminal coupled to said current source (43); and
   an MOS transistor (34) having a first current electrode coupled to said second terminal of said first resistor (31), a gate for receiving a CMOS-level signal, and a second current electrode coupled to said second terminal of said voltage dropping means (43).

2. The BICMOS logic circuit (30, 30', 50) of claim 1 further comprising an input transistor (36) having a collector coupled to said second terminal of said first resistor (31), a base for receiving an input signal of a predetermined logic level, and an emitter coupled to said emitter of said reference transistor (37).

3. The BICMOS logic circuit (30) of claim 1 wherein said voltage dropping means (39) comprises:

   a first diode (40) having a positive terminal coupled to said emitter of said reference transistor (37), and a negative terminal; and
   a second diode (41) having a positive terminal coupled to said negative terminal of said first diode (40), and a negative terminal coupled to said current source (43).

4. The BICMOS logic circuit (30') of claim 1 wherein said voltage dropping means (39') further comprises a diode (40) having a positive terminal coupled to said emitter of said reference transistor (37), and a negative terminal coupled to said current source (43).

5. The BICMOS logic circuit (50) of claim 1 wherein said voltage dropping means (39', 51) comprises:

   series gating means (51), coupled to said emitter of said reference transistor (37), for selectively diverting a current of said current source (43) through either said first resistor (31) or said reference transistor (37) in response to a second input signal; and

dropping means (39') coupled to said series gating means (51) and to said current source (43), for dropping said voltage differential.

6. The BICMOS logic circuit (50) of claim 5 wherein said series gating means (51) comprises:

a second transistor (52) having a collector coupled to said second terminal of said first resistor (31), a base for receiving a third input signal, and an emitter;

a third transistor (53) having a collector coupled to said emitter of said second transistor (52), a base for receiving said second input signal, and an emitter coupled to said dropping means (39'); and

a fourth transistor (54) having a collector coupled to said emitter of said reference transistor (37), a base for receiving a second reference voltage, and an emitter coupled to said emitter of said third transistor (53) and to said dropping means (39').

7. A BICMOS logic circuit (60) comprising a first resistor (31) having a first terminal coupled to a first power supply voltage terminal, and a second terminal for providing a first output signal, a second resistor (32) having a first terminal coupled to said first power supply voltage terminal, and a second terminal for providing a second output signal, an input bipolar transistor (36b) having a collector coupled to said second terminal of said first resistor (31), a base for receiving a first CML-level input signal, and an emitter, a reference bipolar transistor (37) having a collector coupled to said second terminal of said second resistor (32), a base for receiving a reference voltage, and an emitter coupled to said emitter of said input bipolar transistor (36b), and a current source (43) coupled to a second power supply voltage terminal, characterised by further comprising:

dropping means (39") coupled to said current source (43), for providing a voltage differential between first and second terminals of said dropping means (39"), said second terminal of said dropping means (39") coupled to said current source (43);

series gating means (51') coupled to said emitter of said input bipolar transistor (36b) and said reference bipolar transistor (37) and to said first terminal of said dropping means (39"), for selectively diverting a current of said current source (43) through either said first resistor (31) or said emitters of said input bipolar transistor (36b) and said reference bipolar transistor (37), in response to at least one ECL-level input signal; and

an MOS transistor (34') having a first current electrode coupled to said series gating means (51'), a gate for receiving a second CMOS-level input signal, and a second current electrode coupled to said current source (43).

8. The BICMOS logic circuit (60) of claim 7 wherein said series gating means (51') comprises:

a second bipolar transistor (52) having a collector coupled to said second terminal of said first resistor (31), a base for receiving a third input signal, and an emitter;

a third bipolar transistor (53a) having a collector coupled to said emitter of said second bipolar transistor (52), a base for receiving a fourth input signal, and an emitter coupled to said dropping means (39"); and

a fourth bipolar transistor (54) having a collector coupled to said emitter of said reference bipolar transistor (37), a base for receiving a second reference voltage, and an emitter coupled to said emitter of said third bipolar transistor (53a) and to said dropping means (39").

9. The BICMOS logic circuit (60) of claim 8 wherein the first current electrode of said MOS transistor (34') is coupled to said emitter of said second bipolar transistor (52).

**Patentansprüche**

1. Eine BICMOS-Logikschaltung (30, 30', 50), umfassend einen ersten Widerstand (31) mit einem ersten Anschluß, der an einen ersten Energieversorgungsspannungsanschluß gekoppelt ist, und einem zweiten Anschluß, einen zweiten Widerstand (32) mit einem ersten Anschluß, der an den ersten Energieversorgungsspannungsanschluß gekoppelt ist, und einem zweiten Anschluß, einen Referenztransistor (37) mit einem Kollektor, der an den zweiten Anschluß des zweiten Widerstands (32) gekoppelt ist, einer Basis zum Aufnehmen einer Referenzspannung, und einem Emitter, und eine Stromquelle (43), die an einen ersten Energieversorgungsspannungsanschluß gekoppelt ist, dadurch gekennzeichnet, daß sie weiter aufweist:

eine einen Spannungsabfall erzeugende Einrichtung (39, 39', 51) zum Schaffen eines Spannungsdifferentials zwischen einem ersten und einem zweiten Anschluß derselben, wobei der erste Anschluß an den Emitter des Referenztransistors (37) gekoppelt ist, wobei der zweite Anschluß an die Stromquelle (43) gekoppelt ist;

und

einen MOS-Transistor (34) mit einer ersten Stromelektrode, die an den zweiten Anschluß des ersten Widerstands (31) gekoppelt ist, einem Gate zum Aufnehmen eines CMOS-Pegelsignals, und einer zweiten Stromelektrode, die an den zweiten Anschluß der einen Spannungsabfall erzeugenden Einrichtung (43) gekoppelt ist.

2. Die BICMOS-Logikschaltung (30, 30', 50) nach Anspruch 1, weiter umfassend einen Eingangstransistor (36) mit einem Kollektor, der an den zweiten Anschluß des ersten Widerstands (31) gekoppelt ist, einer Basis zum Aufnehmen eines Eingangssignals eines vorbestimmten logischen Pegels, und einem Emitter, der an den Emitter des Referenztransistors (37) gekoppelt ist.

3. Die BICMOS-Logikschaltung (30) nach Anspruch 1, in welcher die einen Spannungsabfall erzeugende Einrichtung (39) aufweist:

eine erste Diode (40) mit einem positiven Anschluß, der an den Emitter des Referenztransistors (37) gekoppelt ist, und einem negativen Anschluß; und

eine zweite Diode (41) mit einem positiven Anschluß, der an den negativen Anschluß der ersten Diode (40) gekoppelt ist, und einem negativen Anschluß, der an die Stromquelle (43) gekoppelt ist.

4. Die BICMOS-Logikschaltung (30') nach Anspruch 1, in welcher die einen Spannungsabfall erzeugende Einrichtung (39') weiter eine Diode (40) mit einem positiven Anschluß, der an den Emitter des Referenztransistors (37) gekoppelt ist, und einem negativen Anschluß, der an die Stromquelle (43) gekoppelt ist, aufweist.

5. Die BICMOS-Logikschaltung (50) nach Anspruch 1, in welcher die einen Spannungsabfall erzeugende Einrichtung (39', 51) aufweist:

eine Reihen-Gating-Einrichtung (51), die an den Emitter des Referenztransistors (37) gekoppelt ist, um als Antwort auf ein zweites Eingangssignal einen Strom der Stromquelle (43) selektiv durch entweder den ersten Widerstand (31) oder den Referenztransistor (37) abzuleiten; und

eine einen Abfall erzeugende Einrichtung (39'), die an die Reihen-Gating-Einrichtung (51) und an die Stromquelle (43) gekoppelt ist, um das Spannungsdifferential abfallen zu lassen.

6. Die BICMOS-Logikschaltung (50) nach Anspruch 5, in welcher die Reihen-Gating-Einrichtung (51) aufweist:

einen zweiten Transistor (52) mit einem Kollektor, der an den zweiten Anschluß des ersten Widerstands (31) gekoppelt ist, einer Basis zum Aufnehmen eines dritten Eingangssignals und einem Emitter;

einen dritten Transistor (53) mit einem Kollektor, der an den Emitter des zweiten Transistors (52) gekoppelt ist, einer Basis zum Aufnehmen des zweiten Eingangssignals und einem Emitter, der an die einen Abfall erzeugende Einrichtung (39') gekoppelt ist; und

einen vierten Transistor (54) mit einem Kollektor, der an den Emitter des Referenztransistors (37) gekoppelt ist, einer Basis zum Aufnehmen einer zweiten Referenzspannung, und einem Emitter, der an den Emitter des dritten Transistors (53) und an die einen Abfall erzeugende Einrichtung (39') gekoppelt ist.

7. Eine BICMOS-Logikschaltung (60), umfassend einen ersten Widerstand (31) mit einem ersten Anschluß, der an einen ersten Energieversorgungsspannungsanschluß gekoppelt ist, und einem zweiten Anschluß zum Liefern eines ersten Ausgangssignals, einen zweiten Widerstand (32) mit einem ersten Anschluß, der an den ersten Energieversorgungsspannungsanschluß gekoppelt ist, und einem zweiten Anschluß zum Liefern eines zweiten Ausgangssignals, einen bipolaren Eingangstransistor (36b) mit einem Kollektor, der an den zweiten Anschluß des ersten Widerstands (31) gekoppelt ist, einer Basis zum Aufnehmen eines ersten CML-Pegel-Eingangssignals, und einem Emitter, einen bipolaren Referenztransistor (37) mit einem Kollektor, der an den zweiten Anschluß des zweiten Widerstands (32) gekoppelt ist, einer Basis zum Aufnehmen einer Referenzspannung und einem Emitter, der an den Emitter des bipolaren Eingangstransistors (36b) gekoppelt ist, und eine Stromquelle (43), die an einen zweiten Energieversorgungsspannungsanschluß gekoppelt ist, dadurch gekennzeichnet, daß sie weiter aufweist:

eine einen Abfall erzeugende Einrichtung (39"), die an die Stromquelle (43) gekoppelt ist, um ein Spannungsdifferential zwischen einem ersten und einem zweiten Anschluß der einen Abfall erzeugenden Einrichtung (39") zu schaffen, wobei der zweite Anschluß der einen Abfall erzeugenden Einrichtung (39") an die Stromquelle (43) gekoppelt ist;

eine Reihen-Gating-Einrichtung (51'), die an den Emitter des bipolaren Eingangtransistors (36b) und des bipolaren Referenztransistors (37) und den ersten Anschluß der einen Abfall erzeugenden Einrichtung (39'') gekoppelt ist, um als Antwort auf wenigstens ein ECL-Pegel-Eingangssignal einen Strom der Stromquelle (43) selektiv durch entweder den ersten Widerstand (31) oder die Emitter des bipolaren Eingangstransistors (36b) und des bipolaren Referenztransistors (37) abzuleiten; und

einen MOS-Transistor (34') mit einer ersten Stromelektrode, die an die Reihen-Gating-Einrichtung (51') gekoppelt ist, einem Gate zum Aufnehmen eines zweiten CMOS-Pegeleingangssignals und einer zweiten Stromelektrode, die an die Stromquelle (43) gekoppelt ist.

8. Die BICMOS-Logikschaltung (60) nach Anspruch 7, in welcher die Reihen-Gating-Einrichtung (51') aufweist:

einen zweiten bipolaren Transistor (52) mit einem Kollektor, der an den zweiten Anschluß des ersten Widerstands (31) gekoppelt ist, einer Basis zum Aufnehmen eines dritten Eingangssignals, und einem Emitter;

einen dritten bipolaren Transistor (53a) mit einem Kollektor, der an den Emitter des zweiten bipolaren Transistors (52) gekoppelt ist, einer Basis zum Aufnehmen eines vierten Eingangssignals und einem Emitter, der an die einen Abfall erzeugende Einrichtung (39'') gekoppelt ist; und

einen vierten bipolaren Transistor (54) mit einem Kollektor, der an den Emitter des bipolaren Referenztransistors (37) gekoppelt ist, einer Basis zum Aufnehmen einer zweiten Referenzspannung, und einem Emitter, der an den Emitter des dritten bipolaren Transistors (53a) und an die einen Abfall erzeugende Einrichtung (39'') gekoppelt ist.

9. Die BICMOS-Logikschaltung (60) nach Anspruch 8, in welcher die erste Stromelektrode des MOS-Transistors (34') an den Emitter des zweiten bipolaren Transistors (52) gekoppelt ist.

**Revendications**

1. Circuit logique BICMOS (30, 30', 50) comprenant une première résistance (31) ayant une première borne raccordée à une première borne de tension d'alimentation, et une seconde borne, une seconde résistance (32) ayant une première borne raccordée à ladite première borne de tension d'alimentation, et une seconde borne, un transistor de référence (37) ayant un collecteur raccordé à ladite seconde borne de ladite seconde résistance (32), une base pour recevoir une tension de référence et un émetteur, et une source de courant (43) raccordée à une première borne de tension d'alimentation, caractérisé en ce qu'il comprend, en outre :

un moyen de chute de tension (39, 39', 51) pour délivrer un différentiel de tension entre ses première et seconde bornes, ladite première borne étant raccordée audit émetteur dudit transistor de référence (37), ladite seconde borne étant raccordée à ladite source de courant (43) ; et un transistor MOS (34) ayant une première électrode de courant raccordée à ladite seconde borne de ladite première résistance (31), une grille pour recevoir un signal de niveaux CMOS, et une seconde électrode de courant raccordée à ladite seconde borne dudit moyen de chute de tension (43).

2. Circuit logique BICMOS (30, 30', 50) selon la revendication 1, comprenant, en outre, un transistor d'entrée (36) ayant un collecteur raccordé à ladite seconde borne de ladite première résistance (31), une base pour recevoir un signal d'entrée d'un niveau logique prédéterminé, et un émetteur raccordé audit émetteur dudit transistor de référence (37).

3. Circuit logique BICMOS (30) selon la revendication 1, dans lequel ledit moyen de chute de tension (39) comprend :

une première diode (40) ayant une borne positive raccordée audit émetteur dudit transistor de référence (37), et une borne négative ; et une seconde diode (41) ayant une borne positive raccordée à ladite borne négative de ladite première diode (40), et une borne négative raccordée à ladite source de courant (43).

4. Circuit logique BICMOS (30') selon la revendication 1, dans lequel ledit moyen de chute de tension (39') comprend, en outre, une diode (40) ayant une borne positive raccordée audit émetteur dudit transistor de référence (37), et une borne négative raccordée à ladite source de courant (43).

5. Circuit logique BICMOS (50) selon la revendication 1, dans lequel ledit moyen de chute de tension (39', 51) comprend :

un moyen de porte en série (51), raccordé audit émetteur dudit transistor de référence (37), pour dévier de manière sélective le courant de ladite source de courant (43) vers soit ladite première résistance (31) soit ledit transistor de référence (37) en réponse à un second signal d'entrée ; et

un moyen de chute (39') raccordé audit moyen de porte en série (51) et à ladite source de courant (43), pour faire chuter ledit différentiel de tension.

6.  Circuit logique BICMOS (50) selon la revendication 5, dans lequel ledit moyen de porte en série (51) comprend :

    un deuxième transistor (52) ayant un collecteur raccordé à ladite seconde borne de ladite première résistance (31), une base pour recevoir un troisième signal d'entrée, et un émetteur ;

    un troisième transistor (53) ayant un collecteur raccordé audit émetteur dudit deuxième transistor (52), une base pour recevoir ledit deuxième signal d'entrée, et un émetteur raccordé audit moyen de chute (39') ; et

    un quatrième transistor (54) ayant un collecteur raccordé audit émetteur dudit transistor de référence (37), une base pour recevoir une seconde tension de référence, et un émetteur raccordé audit émetteur dudit troisième transistor (53) et audit moyen de chute (39').

7.  Circuit logique BICMOS (60) comprenant une première résistance (31) ayant une première borne raccordée à une première borne de tension d'alimentation, et une seconde borne pour délivrer un premier signal de sortie, une seconde résistance (32) ayant une première borne raccordée à ladite première borne de tension d'alimentation, et une seconde borne pour délivrer un second signal de sortie, un transistor bipolaire d'entrée (36b) ayant un collecteur raccordé à ladite seconde borne de ladite première résistance (31), une base pour recevoir un premier signal d'entrée de niveaux CML, et un émetteur, un transistor de référence (37) ayant un collecteur raccordé à ladite seconde borne de ladite seconde résistance (32), une base pour recevoir une tension de référence et un émetteur raccordé audit émetteur dudit transistor bipolaire d'entrée (36b), et une source de courant (43) raccordée à une seconde borne de tension d'alimentation, caractérisé en ce qu'il comprend, en outre :

    un moyen de chute (39") raccordé à ladite source de courant (43), pour délivrer un différentiel de tension entre des première et seconde bornes dudit moyen de chute (39"), ladite seconde borne dudit moyen de chute (39") étant raccordée à ladite source de courant (43) ;

un moyen de porte en série (51') raccordé audit émetteur dudit transistor bipolaire d'entrée (36b) et audit transistor bipolaire de référence 37 et à ladite première borne dudit moyen de chute (39"), pour dévier de manière sélective le courant de ladite source de courant (43) vers soit ladite première résistance (31) soit lesdits émetteurs dudit transistor bipolaire d'entrée (36b) et dudit transistor bipolaire de référence (37), en réponse à au moins un signal d'entrée de niveaux ECL ; et

un transistor MOS (34') ayant une première électrode de courant raccordée audit moyen de porte en série (51'), une grille pour recevoir un second signal d'entrée de niveaux CMOS, et une seconde électrode de courant raccordée à ladite source de courant (43).

8.  Circuit logique BICMOS (60) selon la revendication 7, dans lequel ledit moyen de porte en série (51') comprend :

    un deuxième transistor bipolaire (52) ayant un collecteur raccordé à ladite seconde borne de ladite première résistance (31), une base pour recevoir un troisième signal d'entrée, et un émetteur ;

    un troisième transistor bipolaire (53a) ayant un collecteur raccordé audit émetteur dudit deuxième transistor bipolaire (52), une base pour recevoir un quatrième signal d'entrée, et un émetteur raccordé audit moyen de chute (39") ; et

    un quatrième transistor bipolaire (54) ayant un collecteur raccordé audit émetteur dudit transistor bipolaire de référence (37), une base pour recevoir une seconde tension de référence, et un émetteur raccordé audit émetteur dudit troisième transistor bipolaire (53a) et audit moyen de chute (39").

9.  Circuit logique BICMOS (60) selon la revendication 8, dans lequel la première électrode de courant dudit transistor MOS (34') est raccordée audit émetteur dudit deuxième transistor bipolaire (52).

**FIG.1**
-PRIOR ART-

**FIG.2**

*FIG.3*

$V_{CC}$

31

32

$\overline{V_{OUT}}$

$V_{OUT}$

34

36

37

$V_{IN1}$

$V_{IN2}$

$V_{REF1}$

52

$V_{IN3}$

$V_{REF2}$

53

54

51

39'

40

42

43

$V_{SS}$

50

*FIG.4*

*FIG.5*